# EUROPEAN PATENT APPLICATION

(11) **EP 4 622 100 A1**
(43) Date of publication of application: **24.09.2025**
(21) Application number: 24165475.5
(22) Date of filing: 22.03.2024
(51) Int. Cl.: H03F 3/189, H03F 7/00

(54) **A CRYOGENIC AMPLIFICATION DEVICE**

(71) Applicant: Österreichische Akademie der Wissenschaften, 1010 Wien (AT)
(72) Inventor: Schmidt, Philip, 1090 Wien (AT); Sezer, Ugur, 1090 Wien (AT); Zemlicka, Martin, 1090 Wien (AT); Neilinger, Pavol, 84248 Bratislava (SK); Kern, Samuel, 84248 Bratislava (SK)
(74) Representative: Leinweber & Zimmermann

(57) **Abstract**

A cryogenic amplification device (1) is according to the invention configured to include at least two parallel parametric amplification lines (7, 8) to thereby enable reduction of gain ripples in the total frequency spectrum of the amplifier bandwidth. (Fig. 1)

## Description

The invention relates to a cryogenic amplification device configured to receive an input microwave signal to be amplified at an input thereof, parametrically amplify the input signal and provide the amplified input signal at an output thereof, and to a method of operating such a cryogenic amplification device.

Such amplification devices are typically used to read out qubits, in particular superconducting qubits and specifically transmons. They are for this purpose arranged on the mixing chamber stage after the qubits as the first member in the amplification chain. Typically, these amplification devices are of the Josephson parametric amplifier type.

Parametric amplifiers (paramps) utilizing Josephson junctions (JJs) have a rich history dating back to 1967 [Zim67, KS71, FPC75]. While some technical advancements have been made throughout in the past [BPR⁺87, BLP⁺89, OC88, YRMP96], recent advances in circuit quantum electrodynamics (c-QED), particularly the development of dispersive qubit state measurement [WSB⁺04] and the emergence of the superconducting transmon qubit [KYG⁺07], have triggered significant research interest and upgrades, as demonstrated in references [CBL07, YIW⁺08]. The combination of parametric amplification and dispersive measurement was first showcased in reference [VSS11], enabling single-shot read-out.

With the increasing use of multi-qubit chips, there is a growing desire for frequency multiplexing and enhanced bandwidth. The Josephson traveling-wave parametric amplifier (JTWPA) [OMSZ14], similar to classical broadband amplifiers in traveling-wave geometry [Poz12], has become popular. A fruitful strategy for design optimization involves periodic loading of the transmission line with compact lumped-element resonators [MOH⁺15]. However, this approach can lead to gain ripples in the frequency spectrum and a gain gap. It is worth mentioning other realizations, such as those described in references [Zor16, ZHGB17], as well as leveraging the nonlinear inductance of high-kinetic-inductance superconducting materials [CLI⁺17].

For an overview of present techniques, reference is made to [Aum20]. The fundamentals of noise, measurement, and amplification are for example discussed in [CDG⁺].

A broadband amplifier with a high signal-to-noise ratio is required in many applications, such as qubit read-out multiplexing, particle detection, and quantum systems' fast response measurement. Moreover, as the noise figure of the read-out setup is to be minimized, the amplifier has to be instated close to the measured system. Thus, it must work at ultra-low temperatures, have low heat dissipation, and should introduce minimal measurement distortion. Optimally, for future scaling up of quantum systems, it must be fully integrable to the quantum system.

Amplifiers, which are close to fulfilling these requirements are the traveling wave parametric amplifiers (TWPAs), which are widely utilized in such experiments. They exploit a waveguide with a nonlinear element (either Josephson junctions or a high kinetic inductance superconductor) interacting between a strong pump and amplified signal. The phase-matching, known from nonlinear optics, ensures high gain and wide bandwidth but also results in a complicated design and demanding fabrication process.

Ideally, the waveguide is impedance-matched to the standard 50-ohm circuitry. This can be achieved by impedance-matched elements, such as adiabatic tapers, or fabricating waveguides with 50-ohm impedance, for example by increased ground capacitance to compensate the high inductance of the waveguide. Whereas both strategies are feasible, in real conditions the results are not satisfactory and the biggest drawback of the state-of-the-art TWP is the gain ripples, which can be more than 5 dB amplitude. This is because the waveguides are nonlinear and thus extremely sensitive to any variance in parameters, such as pump power, signal power, temperature, fabrication imperfections, and reflections in the measurement setup. The most successful strategy is to design tunable amplifiers. However, a satisfactory reduction of gain ripples is obtained on the amplification's (gain) cost.

Another approach to mitigate the reflections and flatten the bandwidth of resonantly phase-matched TWPAs, is the balanced amplifiers network commonly applied to transistor amplifiers, as was very recently suggested [1], [2]. The balanced amplifiers are two identical amplifiers connected in parallel in a such way that the signal is divided and combined by pi/2 hybrid couplers. The waves reflected from the identical amplifiers are added destructively in the couplers and the network is matched.

However, the reflection cancellation requires the amplifiers to be identical, without any imperfections present along the waveguides. To achieve this in complex devices like TWPAs consisting of thousands of junctions or structures securing the phase-matching seems to be impossible. As a result, the reflection cancellation in real conditions will be weak, the ripples will persist and the effect of couplers could be even the opposite, increasing the reflections. Furthermore, in many TWPA designs magnetic flux biasing is required, which if not perfectly spatially homogenous can lead to the failure of the balanced network [2], too.

It is an object of the present invention to improve the overall characteristics of an amplification device of the above-referenced type.

This object is according to the invention attained by a cryogenic amplification device of the above-referenced type comprising: an input node connected to receive the input signal from the input of the amplification device and configured to divide the input signal into a number of two or more partial signals; a corresponding number of individual parametric amplifiers, each connected to receive one of the partial signals from the input node and configured to parametrically amplify the received partial signal, at least a first one of the individual parametric amplifiers being configured to have the frequency position of the gain profile of the amplified partial signal displaced relative to the frequency position of the gain profile of the amplified partial signal of at least a second one of the other individual parametric amplifiers; and an output node connected to receive the amplified partial signals from the parametric amplifiers and configured to combine the received amplified partial signals, and connected to provide the combined signal at the output of the amplification device.

According to the invention, multiple individual parametric amplifiers, preferably of the Josephson parametric amplifier type, are connected in parallel. Thereby, the overall characteristics of the amplification device are improved. Specifically, the read-out performance is improved thereby allowing faster measurements. In addition, the gain curve is smoothed in particular by the phase delay of at least one path specifically due to tuning the length or the phase velocity of the amplifier medium, in particular of a transmission line resonator of the amplifier, which reduces calibration and post-processing.

The amplification device of the invention may provide higher read-out power. Specifically, the increase of the highest read-out power may be 100 percent or more. As a consequence, the measurement time may for instance be reduced by a factor of more than 1.4. In addition, gain ripples in the frequency spectrum after smoothing may typically reach 1.5 dB or less. Further, the number of computational error corrections caused by read-out may be reduced. Also, read-out over a larger frequency range is simplified and more consistent.

Specifically, the invention is useful in measuring quantum signals, e.g., qubits, that need low noise detection. In superconducting microwave circuits, the noise limit is set by the primary amplifier noise temperature in the signal chain. Using the amplification device according to the invention as the primary amplifier makes a significant contribution to enable detection near the quantum limit. This enables, e.g., in quantum computers, a faster and more precise read-out of the quantum states. The field of use of the invention ranges from quantum computing, quantum sensor technology to quantum communication.

Specifically, the input signal is in accordance with the invention divided in such a way that the partial signals have the same signal power.

According to the invention, the amplifiers, specifically travelling-wave parametric amplifiers (TWPAs), are connected in parallel by a power divider that does not introduce a 90deg phase shift (for example, Wilkinson power divider). Specifically, the amplifiers are unmatched, or not ideally matched, thus ripples are present in the transmission profile. The frequency position of a ripple peak in the transmission profile is proportional to the ratio of its phase velocity and physical length [1]. Therefore, a slight change in phase velocity or the waveguide's length shifts the peak position.

By tuning the difference in the length or the phase velocity of the amplifiers the relative position of the ripples can be tuned to cancel out each other at the output of the integrated system. Thus, for two parallel TWPAs, the ripple peak of the first TWPA occurs at the frequency position where the second TWPA exhibits a dip in its transmission profile. Combining outputs of such two amplifiers results in significant flattening of the transmission profile.

In an expedient embodiment of the invention, at least one of the connections between one of the input or output nodes and one of the parametric amplifiers is via an isolator, in particular a circulator having one port thereof terminated. The circulator imposes unidirectional routing of the signals and protects from unwanted noise originated from the outside as well as reflections caused by back-action/amplification. For more details of the operation, reference is made to [ABJ⁺]. Specifically, the isolator may be inserted into the connection between the input node and selected ones or all of the individual parametric amplifiers and/or may be inserted into the connection between the output node and selected ones or all of the individual parametric amplifiers.

In another expedient embodiment, the input node is a waveguide type divider, in particular of a coplanar, stripline or coaxial configuration. Thereby, a wide bandwidth and a low power loss may be attained.

In still another expedient embodiment, at least one of the input or output nodes is a Wilkinson type divider/combiner. Wilkinson type dividers/combiners are a robust design and of a low insertion loss.

In another exemplary embodiment, at least one of the parametric amplifiers is a standing wave amplifier. Due to the resonant amplification in the standing wave amplifier, a high gain and low noise is attained. Bandwidth is, however, limited to the bandwidth of the standing wave amplifier.

In an alternative embodiment, at least one of the parametric amplifiers is a traveling wave amplifier. This has the advantage of a very high bandwidth and is specifically suitable for quantum computing applications.

According to another aspect of the invention, a phase delay is provided between at least two of the partial signals. This may be attained by tuning the signal phase at the input of at least one of the parametric amplifiers, for instance by correspondingly varying pump phases or operating points of the amplifiers. Alternatively, phase shifting electronic components may be used.

In still another expedient embodiment, a dedicated pump input is provided for at least one of the parametric amplifiers. While the provision of a single pump for all of the individual parametric amplifiers results in a simple construction, the use of one or more dedicated pumps for one or more of the parametric amplifiers causes the corresponding noise to be uncorrelated.

According to another aspect of the invention, at least two of the parametric amplifiers are monolithically integrated on a single chip. Thereby, space requirement is reduced as is beneficial for locating the cryogenic amplification device in the cryogenic zone of a quantum computing device. Further, it is simpler in design, easier to build and more robust. Preferably, all components including the input node, the output node, and the individual parametric amplifiers are monolithically integrated on one chip so that the whole microwave path from the input node to the output node is confined to this chip.

Within the scope of the invention, there is also provided a method of operating a cryogenic amplification device, wherein a phase delay between partial signals is tuned so as to reduce a ripple component of the gain of the individual amplifiers in the amplified signal at the output. While it is basically sufficient to tune a phase of only one of the partial signals, preferably the phase is of at least two up to all of the partial signals are being tuned.

In particular, the 1 dB gain compression point is controlled so as to be higher than the ones of the individual amplifiers. For this purpose, the individual amplifiers should have equal saturation points.

Specifically, the 1 dB gain compression point is increased by increasing the number of individual amplifiers.

According to another aspect of the invention, the individual amplifier noise is added uncorrelated. This is for instance attained by providing separate individual pumps for each of the individual amplifiers.

Preferably, the noise of the partial signals is reduced in the amplified input signal at the output of the amplification device. For this purpose, the average gain of the individual amplifiers should be equal.

In the following, the invention is further exemplarily explained with reference to the drawings in which:
- Fig. 1: schematically shows an embodiment of a cryogenic amplification device in accordance with the invention;
- Figs. 2(a) and (b): schematically show modifications of the embodiment of Fig. 1; and
- Fig. 3: shows a typical gain curve of an embodiment in accordance with the invention.

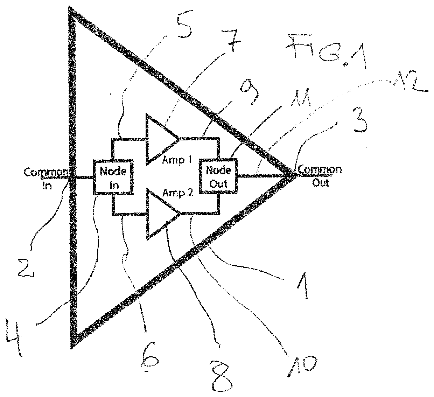

A cryogenic amplification device 1 schematically shown in Fig. 1 has an input 2 for receiving an input microwave signal to be amplified, and an output 3 for the amplified input signal. From the input 2, the input signal is forwarded to an input node 4 which is operative to divide the input signal into two partial signals. The two partial signals are forwarded from the input node 4 on a first signal path 5 and a second signal path 6 to a first parametric amplifier 7 and a second parametric amplifier 8, respectively. The parametrically amplified partial signals are forwarded from the first and second amplifiers 7, 8 on a third signal path 9 and a fourth signal path 10, respectively, to an output node 11 that is operative to combine the received amplified partial signals and forwards the combined signal on a fifth signal path 12 to the output 3.

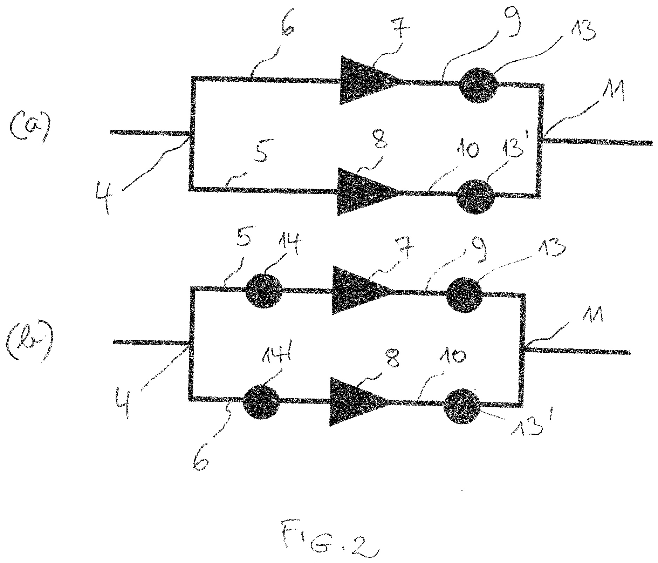

The embodiments shown in Figures 2(a) and (b) correspond to the embodiment of Fig. 1 having an additional circuit element added thereto. The same reference numerals as in Fig. 1 are used in Fig. 2 for the elements already present in the embodiment of Fig. 1.

In the embodiment of Fig. 2(a), each of an isolator 13, 13', in particular a terminated circulator, is interposed in the third and fourth signal path, respectively, between the first and second amplifiers 7, 8 and the output node 11 of the embodiment of Fig. 1. In the embodiment of Fig. 2(b), similar isolators 14, 14' are additionally interposed in the first and second signal paths, respectively, between the input node 4 and the first and second amplifiers 7, 8 of the embodiment of Fig. 1.

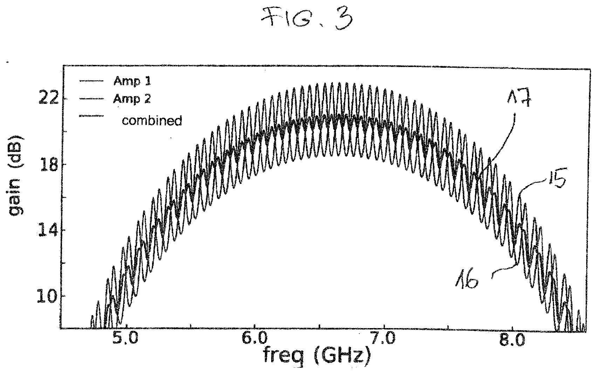

In Fig. 3, reference numeral 15 designates the gain versus frequency curve (thin line) of the first amplifier 7, reference numeral 16 designates the gain versus frequency curve (thin line) of the second amplifier 8, and reference numeral 17 designates the gain versus frequency curve (bold line) of the cryogenic amplification device 1. As is illustrated in Fig. 3, ripple in the gain versus frequency curve 17 of the amplification device 1 is strongly suppressed as a result of destructive interference between the larger ripple from the individual first and second amplifiers 7, 8, respectively.

To illustrate the aforementioned effects, the gain for TWPAs similar to the one presented in Ref. [4] was evaluated. The gain was modelled by the modified coupled mode theory with reflections, which were recently developed [3] and which enables a convenient and straightforward evaluation of unmatched amplifiers. The gain profiles of the first TWPA and the second TWPA characteristically rippled are depicted as blue and red, respectively. The visible shift of the ripple profile is introduced by the increased electrical length δ = 1 % of one of the amplifiers.

This shift is for example by a 1 % increase of the second TWPA length, or by decreasing the phase velocity by changing the waveguide permittivity, tuning its inductance by bias current or flux. This way, the phase shift causes a shift of ripple peaks of the second TWPA to frequencies where the first one has its dips. As a result, the combination of the transmissions exhibits smaller ripples. Also, the peaks originally wide, Δf = 20 MHz, are now two times narrower. The effect is maximal in the gain maximum, otherwise, far from the maximum, the peaks are getting stronger.

This effect can be utilized with any type of TWPA. However, the electrical length necessary to obtain sufficient gain varies. For example, the kinetic inductance TWPA achieves less nonlinearity, thus a very long waveguide (~0.5 m) is necessary to achieve decent gain. This results in very sharp (-10 MHz wide) and irregular ripples, which are hard to cancel out. However, moderate gain (-10 dB) can be obtained at much lower length even with KITWPA, utilizing enhanced capacity [3]. Following is a review of a few TWPAs based on different technologies and ripple width and necessary asymmetry:
- KITWPA
   ∘ Eom et. al. [4] Δf = 20 MHz, vp = 0.1c, I = 800 mm, δ = 0.16%
   ∘ Adamyan et. al. [5] Δf = 43 MHz, vp = 0.03c, I = 114 mm, δ = 0.38%
   ∘ Klimovich et. al. [6] Δf = 10 MHz, vp = 0.01c, I = 86 mm, δ = 0.083%
- JJTWPA
   ∘ White et. al. [7] Δf = 100 MHz, vp = 0.044c, I = 66 mm, δ = 0.8%
   ∘ Kern et. al. [3] Δf = 500 MHz, vp = 0.14c, I = 11 mm, δ = 4.16%
- SQUID TWPA
   ∘ Planat et. al. [8] Δf = 100 MHz, vp = 0.0067c, I = 6.6 mm, δ = 0.8%
- SNAILS
   ∘ Ranadive et. al. [9] Δf = 110 MHz, I = 6 mm, δ = 0.9%

### List of reference signs:

- 1: cryogenic amplification device
- 2: input
- 3: output
- 4: input node
- 5: first signal path
- 6: second signal path
- 7: first amplifier
- 8: second amplifier
- 9: third signal path
- 10: fourth signal path
- 11: output node
- 12: fifth signal path
- 13, 13': isolator
- 14, 14': isolator
- 15: gain versus frequency curve
- 16: gain versus frequency curve
- 17: gain versus frequency curve

### References

| | |
|---|---|
| [ABJ⁺] | Baleegh Abdo, Nicholas T. Bronn, Oblesh Jinka, Salvatore Olivadese, Antonio D. Córcoles, Vivekananda P. Adiga, Markus Brink, Russel E. Lake, Xian Wu, David P. Pappas & Jerry M. Chow. Active protection of a superconducting qubit with an interferometric Josephson isolator. NATURE COMMUNICATIONS, (2019)10:3154. |
| [Aum20] | J. Aumentado. Superconducting parametric amplifiers: The state of the art in Josephson parametric amplifiers. IEEE Microwave Magazine, 21:45-49, 2020. |
| [BLP⁺89] | B. Yurke, L. R. Corruccini, P. G. Kaminsky, L. W. Rupp, A. D. Smith, A. H. Silver, R. W. Simon, and E. A. Whittaker. Observation of parametric amplification and deamplification in a Josephson parametric amplifier. Phys. Rev. A, 39(5):2519, 1989. |
| [BPR⁺87] | B. Yurke, P. G. Kaminsky, R. E. Miller, E. A. Whittaker, A. D. Smith, A. H. Silver, and R. W. Simon. Observation of 4.2-k equilibrium-noise squeezing via a Josephson-parametric amplifier. Physical Review Letters, 60(9):764, 1987. |
| [CBL07] | M. A. Castellanos-Beltran and K. W. Lehnert. Widely tunable parametric amplifier based on a superconducting quantum interference device array resonator. Applied Physics Letters, 91(8):083509, 2007. |
| [CDG⁺] | A. A. Clerk, M. H. Devoret, S. M. Girvin, Florian Marquardt, and R. J. Schoelkopf. Introduction to quantum noise, measurement, and amplification. Rev. Mod. Phys. 82, 1155, 2010. |
| [CLI⁺17] | S. Chaudhuri, D. Li, K. D. Irwin, C. Bockstiegel, J. Hubmayr, J. N. Ullom, M. R. Vissers, and J. Gao. Broadband parametric amplifiers based on nonlinear kinetic inductance artificial transmission lines. Applied Physics Letters, 110(15), 2017. |
| [FPC75] | M. J. Feldman, P. T. Parrish, and R. Y. Chiao. Parametric amplification by unbiased Josephson junctions. Journal of Applied Physics, 46(9):4031-4042, 1975. |
| [KS71] | H. Kanter and A. H. Silver. Self-pumped Josephson parametric amplification. Applied Physics Letters, 19(12):515-517, 1971. |
| [KYG⁺07] | Jens Koch, Terri M. Yu, Jay Gambetta, A. A. Houck, D. I. Schuster, J. Majer, Alexandre Blais, M. H. Devoret, S. M. Girvin, and R. J. Schoelkopf. Charge-insensitive qubit design derived from the cooper pair box. Physical Review A, 76(4), 2007. |
| [MOH⁺15] | C. Macklin, K. O'Brien, D. Hover, M. E. Schwartz, V. Bolkhovsky, X. Zhang, W. D. Oliver, and I. Siddiqi. A near-quantum-limited Josephson traveling-wave parametric amplifier. Science (New York, N.Y.), 350(6258):307-310, 2015. |
| [OC88] | H. K. Olsson and T. Claeson. Low-noise Josephson parametric amplification and oscillations at 9 ghz. Journal of Applied Physics, 64(10):5234-5243, 1988. |
| [OMSZ14] | Kevin O'Brien, Chris Macklin, Irfan Siddiqi, and Xiang Zhang. Resonant phase matching of Josephson junction traveling wave parametric amplifiers. Physical review letters, 113(15):157001, 2014. |
| [Poz12] | David M. Pozar. Microwave engineering. John Wiley & Sons, Inc., Hoboken, NJ, 4th edition, 2012. |
| [VSS11] | R. Vijay, D. H. Slichter, and I. Siddiqi. Observation of quantum jumps in a superconducting artificial atom. Physical review letters, 106(11):110502, 2011. |
| [WSB⁺04] | A. Wallraff, D. I. Schuster, A. Blais, L. Frunzio, R-S Huang, J. Majer, S. Kumar, S. M. Girvin, and R. J. Schoelkopf. Strong coupling of a single photon to a superconducting qubit using circuit quantum electrodynamics. Nature, 431 (7005): 162-167, 2004. |
| [YIW⁺08] | T. Yamamoto, K. Inomata, M. Watanabe, K. Matsuba, T. Miyazaki, W. D. Oliver, Y. Nakamura, and J. S. Tsai. Flux-driven Josephson parametric amplifier. Applied Physics Letters, 93(4):042510, 2008. |
| [YRMP96] | B. Yurke, M. L. Roukes, R. Movshovich, and A. N. Pargellis. A low-noise series-array Josephson junction parametric amplifier. Applied Physics Letters, 69(20):3078-3080, 1996. |
| [ZHGB17] | Wenyuan Zhang, W. Huang, M. E. Gershenson, and M. T. Bell. Josephson metamaterial with a widely tunable positive or negative Kerr constant. Physical Review Applied, 8(5), 2017. |
| [Zim67] | H. Zimmer. Parametric amplification of microwaves in superconducting Josephson tunnel junctions. Applied Physics Letters, 10(7):193-195, 1967. |
| [Zor16] | A. B. Zorin. Josephson traveling-wave parametric amplifier with three-wave mixing. Physical Review Applied, 6(3), 2016. |
| [1] | Nilsson, Hampus Renberg, et al. arXiv preprint arXiv:2310.11909 (2023). |
| [2] | D. M. Pozar, Microwave engineering (John Wiley & sons, 2011). |
| [3] | Kern, S., et al., PRB 107.17 (2023): 1747520. |
| [4] | Ho Eom, Byeong, et al., Nature Physics 8.8 (2012): 623-627. |
| [5] | Adamyan, A. A., et al., Journal of Applied Physics 119.8 (2016). |
| [6] | Klimovich, Nikita, et al., arXiv preprint arXiv:2306.11028 (2023). |
| [7] | WHITE, T. C., et al., Applied Physics Letters, 2015, 106.24. |
| [8] | Planat, Luca, et al., Physical Review X 10.2 (2020): 021021. |
| [9] | Ranadive, Arpit, et al., Nature communications 13.1 (2022): 1737 |

## Claims

1. A cryogenic amplification device (1) configured to receive an input microwave signal to be amplified at an input (2) thereof, parametrically amplify the input signal and provide the amplified input signal at an output (3) thereof, comprising:
an input node (4) connected to receive the input signal from the input (2) of the amplification device (1) and configured to divide the input signal into a number of two or more partial signals;
a corresponding number of individual parametric amplifiers (7, 8), each connected to receive one of the partial signals from the input node (4) and configured to parametrically amplify the received partial signal at least a first one of the individual parametric amplifiers being configured to have the frequency position of the gain profile of the amplified partial signal displaced relative to the frequency position of the gain profile of the amplified partial signal of at least a second one of the other individual parametric amplifiers; and
an output node (11) connected to receive the amplified partial signals from the parametric amplifiers (7, 8) and configured to combine the received amplified partial signals, and connected to provide the combined signal at the output (3) of the amplification device (1).

2. A cryogenic amplification device according to claim 1, wherein the displacement of the frequency position is tuned so as to cause destructive interference between a ripple component of the gain profile of the amplified signal of one of the first and second individual parametric amplifiers and a ripple component of the gain profile of the amplified signal of the other one of the first and second individual parametric amplifiers.

3. A cryogenic amplification device according to anyone of claims 1 or 2, wherein the displacement of the frequency position is effected by changing the phase velocity and/or the length of the amplifier medium, in particular of a transmission line resonator of the individual parametric amplifier.

4. The cryogenic amplification device of anyone of claims 1 to 3, wherein at least one of the connections between one of the input or output nodes (4, 11) and one of the parametric amplifiers (7, 8) is via an isolator (13, 13', 14, 14'), in particular a circulator having one port thereof terminated.

5. The cryogenic amplification device of anyone of claims 1 to 4, wherein the input node (4) is a waveguide type divider, in particular of a coplanar, stripline or coaxial configuration.

6. The cryogenic amplification device of anyone of claims 1 to 5, wherein at least one of the input or output nodes (4, 11) is a Wilkinson type divider/combiner.

7. The cryogenic amplification device of anyone of claims 1 to 6, wherein at least one of the parametric amplifiers (7, 8) is a standing wave amplifier.

8. The cryogenic amplification device of anyone of claims 1 to 7, wherein at least one of the parametric amplifiers (7, 8) is a traveling wave amplifier.

9. The cryogenic amplification device of anyone of claims 1 to 8, wherein a phase delay is provided between at least two of the partial signals.

10. The cryogenic amplification device of anyone of claims 1 to 9, wherein a dedicated pump input is provided for at least one of the parametric amplifiers (7, 8).

11. The cryogenic amplification device of anyone of claims 1 to 10, wherein at least two of the parametric amplifiers (7, 8) are monolithically integrated on a single chip.

12. A method of operating a cryogenic amplification device of anyone of claims 1 to 11, wherein a difference between frequency positions of the gain profiles of partial signals is tuned so as to reduce a ripple component of the gain of the individual amplifiers (7, 8) in the amplified combined signal at the output.

13. The method of claim 12, wherein the 1 dB gain compression point is controlled so as to be higher than the ones of the individual amplifiers (7, 8).

14. The method of anyone of claims 12 or 13, wherein the 1 dB gain compression point is increased by increasing the number of individual amplifiers (7, 8).

15. The method of anyone of claims 12 to 14, wherein the individual amplifier noise is added uncorrelated.

16. The method of claim 15, wherein the noise of the partial signals is reduced in the amplified input signal at the output (3) of the amplification device (1).
